# EUROPEAN PATENT APPLICATION

(11) **EP 4 723 115 A1**
(43) Date of publication of application: **08.04.2026**
(21) Application number: 25203812.0
(22) Date of filing: 22.09.2025
(51) Int. Cl.: G11C 7/10

(54) **MEMORY CONTROLLER WITH DYNAMIC SIGNALING SCHEMES**

(30) Priority: 02.10.2024 US 202463702604 P; 02.10.2024 US 202463702607 P; 02.10.2024 US 202463702612 P; 02.10.2024 US 202463702618 P; 19.08.2025 US 202519303432
(71) Applicant: MEDIATEK INC., Hsinchu City 30078 (TW)
(72) Inventor: KUMAR, Arvind, San Jose (US); KUMASHIKAR, Mahesh K., San Jose (US); NALAMALPU, Ankireddy, San Jose (US)
(74) Representative: Haseltine Lake Kempner LLP

(57) **Abstract**

A memory controller in an integrated circuit system performs bi-directional data transfer at a clock frequency between the memory controller and a memory module. The data transfer in a first direction is at a first pulse amplitude modulation (PAM) level and in a second direction at a second PAM level. When receiving an indication of an increased demand for data transfer in the first direction, the memory controller increases the first PAM level to a target PAM level for data transfer in the first direction while maintaining the clock frequency and the second PAM level in the second direction.

## Description

### CROSS-REFERENCE TO RELATED APPLICATIONS

This application claims the benefit of U.S. Provisional Application No. 63/702,604 filed on October 2, 2024, U.S. Provisional Application No. 63/702,607 filed on October 2, 2024, U.S. Provisional Application No. 63/702,612 filed on October 2, 2024, and U.S. Provisional Application No. 63/702,618 filed on October 2, 2024, the entirety of all of which is incorporated by reference herein.

### TECHNICAL FIELD

Embodiments of the invention relate to memory controllers and memory I/O techniques in an integrated circuit system.

### BACKGROUND OF THE INVENTION

Modern memory controllers support high efficiency and low latency data transfer between a processor and a memory device. A memory controller translates and coordinates high-level memory access requests from a processor into low-level electrical signals that read from or write to the memory. Based on the memory access requests, the memory controller determines which row and column in a memory cell array to access.

A memory controller also schedules memory I/O commands from a processor, such as read, write, activate (row access), precharge (row close), and refresh to the memory based on timing rules. Additionally, the memory controller performs timing management and read/write data buffering to manage differences in data rates or timing between the processor and the memory.

The designs of memory controllers continue evolving to support faster, larger, and more power-efficient computing. The demands on memory controllers with respect to timing, power, and reliability continue to grow. Therefore, there is a need for further improvement of memory controller technologies.

### SUMMARY OF THE INVENTION

In one embodiment, a method of a memory controller in an integrated circuit system is provided. The memory controller performs bi-directional data transfer at a clock frequency between the memory controller and a memory module. The data transfer in a first direction is at a first pulse amplitude modulation (PAM) level and in a second direction at a second PAM level. When receiving an indication of an increased demand for data transfer in the first direction, the memory controller increases the first PAM level to a target PAM level for data transfer in the first direction while maintaining the clock frequency and the second PAM level in the second direction.

In another embodiment, a method of a memory controller in an integrated circuit system is provided. The memory controller transmits write data to a memory module at a first PAM level, and receives read data from the memory module at a second PAM level. When receiving an indication of a change in an operating condition that affects performance of the integrated circuit system, the memory controller changes at least one of the first PAM level and the second PAM level in response to the change in the operating condition. Any change to the first PAM level is independent of the second PAM level and any change to the second PAM level is independent of the first PAM level.

In yet another embodiment, an integrated circuit system includes a memory module and a memory controller. The memory module includes one or more memory dies. The memory controller is coupled to the memory module and a processor. The memory controller includes a transmitter circuit and a receiver circuit to perform bi-directional data transfer at a clock frequency with the memory module. The data transfer in a first direction is at a first PAM level and in a second direction at a second PAM level. When receiving an indication of an increased demand for data transfer in the first direction, the memory controller increases the first PAM level to a target PAM level for data transfer in the first direction while maintaining the clock frequency and the second PAM level in the second direction.

Other aspects and features will become apparent to those ordinarily skilled in the art upon review of the following description of specific embodiments in conjunction with the accompanying figures.

### BRIEF DESCRIPTION OF DRAWINGS

The present invention is illustrated by way of example, and not by way of limitation, in the figures of the accompanying drawings in which like references indicate similar elements. It should be noted that different references to "an" or "one" embodiment in this disclosure are not necessarily to the same embodiment, and such references mean at least one. Further, when a particular feature, structure, or characteristic is described in connection with an embodiment, it is submitted that it is within the knowledge of one skilled in the art to effect such feature, structure, or characteristic in connection with other embodiments whether or not explicitly described.
FIG. 1 is a block diagram illustrating an integrated circuit system in which embodiments of the invention may operate.
FIG. 2 is a block diagram illustrating a memory controller and a memory module according to one embodiment.
FIG. 3 is a block diagram illustrating components of a memory controller according to one embodiment.
FIG. 4A is a block diagram illustrating an Rx circuit in a memory controller according to one embodiment.
FIG. 4B is a block diagram illustrating a Tx circuit in a memory controller according to one embodiment.
FIG. 5 is a block diagram illustrating an integrated circuit system in which a memory controller may operate according to another embodiment.
FIG. 6A is a flow diagram illustrating a method performed by a memory controller according to one embodiment.
FIG. 6B is a flow diagram illustrating a method performed by a memory controller according to another embodiment.
FIG. 7A, FIG. 7B, FIG. 7C, and FIG. 7D illustrate a memory controller connecting to different types of memory modules according to some embodiments.

### DETAILED DESCRIPTION OF THE INVENTION

In the following description, numerous specific details are set forth. However, it is understood that embodiments of the invention may be practiced without these specific details. In other instances, well-known circuits, structures, and techniques have not been shown in detail in order not to obscure the understanding of this description. It will be appreciated, however, by one skilled in the art, that the invention may be practiced without such specific details. Those of ordinary skill in the art, with the included descriptions, will be able to implement appropriate functionality without undue experimentation.

This disclosure describes a memory controller that provides dynamically adjustable modulation levels. In one embodiment, the memory controller communicates with a memory module using pulse amplitude modulation (PAM) with adjustable PAM levels. The term "PAM level" refers to the number of distinct voltage levels used to represent symbols transmitted with PAM. For example, "PAM-N" means that N voltage levels are used to represent the symbols transmitted with PAM. In the following description, specific PAM levels are mentioned as examples. It is understood that the disclosed memory controller is not limited to the specific PAM levels mentioned herein.

In one embodiment, the memory controller can transmit data to the memory module at a first PAM level and receive data from the memory module at a second PAM level different from the first PAM level. In one embodiment, the memory controller can respond to changes in runtime operating conditions by adjusting the PAM levels for singledirectional or bi-directional communication with the memory module.

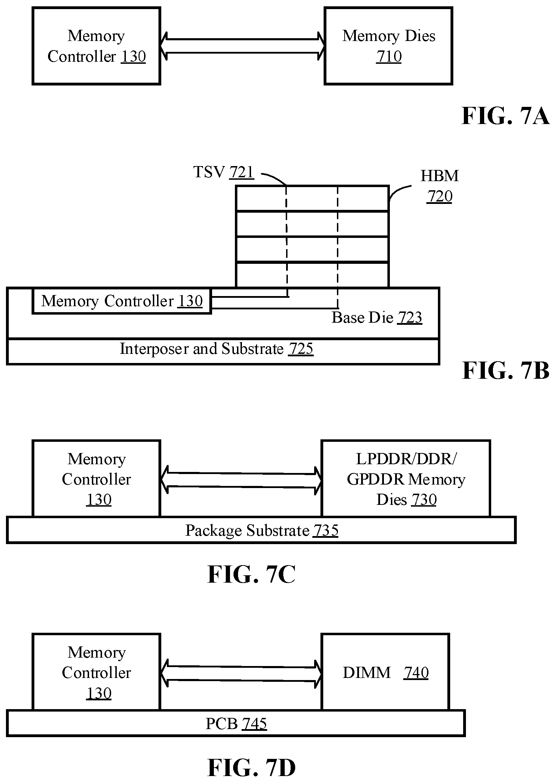

Non-limiting examples of memory modules include: one or more memory dies, a memory chip containing one or more memory dies, a circuit board containing multiple memory chips, each of which containing one or more memory dies. The memory dies in a memory module may be stacked on top of each other and communicate with one another via through-silicon vias (TSVs) or wire bonding. Alternatively, the memory dies in a memory module may be arranged side by side. The memory module may be manufactured by any memory technology that enables PAM communication with a memory controller. Non-limiting examples of the memory modules are provided with reference to FIG. 7A-FIG. 7D.

As used herein, the term "die" refers to a semiconductor integrated circuit on which memory cells and/or logic circuit elements are created. The term "data transfer rate" refers to the rate at which data bits are transferred on a signal lane.

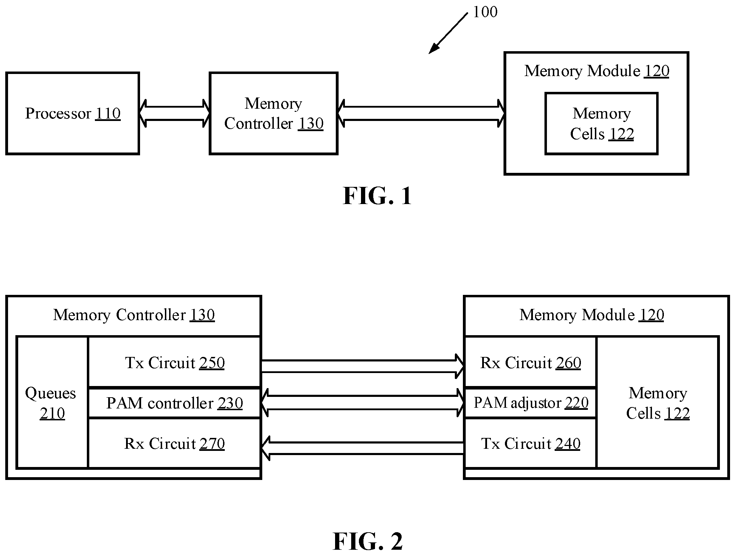

FIG. 1 is a block diagram illustrating an integrated circuit system 100 ("system 100") in which embodiments of the invention may operate. The system 100 includes a processor 110 coupled to a memory controller 130, which reads from and writes to a memory module 120 when directed by the processor 110. The memory module 120 includes arrays of memory cells 122 for data storage. In one embodiment, the memory controller 130 may be co-located with host processor 110 on one chip, and the memory module 120 may be located outside of the chip. In another embodiment, the memory controller 130, the processor 110, and the memory module 120 may all co-located on the same chip.

Although one processor 110 is shown in FIG. 1, it is understood that the system 100 may include multiple processors and each processor may include one or more processing cores or computation units. Non-limiting examples of the processor 110 include, a central processing unit (CPU), a graphics processing unit (GPU), a digital signal processor (DSP), a neural processing unit (NPU), and any processing units that uses a memory controller to access the memory module 120.

FIG. 2 is a block diagram illustrating further details of the memory controller 130 and the memory module 120 according to one embodiment. The memory controller 130 includes a transmitter (Tx) circuit 250, a receiver (Rx) circuit 270, and a PAM controller 230. The Tx circuit 250 and the Rx circuit 270 in the memory controller 130 communicate with an Rx circuit 260 and a Tx circuit 240, respectively, in the memory module 120. The PAM controller 230 in the memory controller 130 controls the PAM levels for communication with the memory module 120. The PAM controller 230 coordinates with a memory-side PAM adjustor 220 regarding the PAM levels to be used for data transmission and reception. More specifically, when the PAM controller 230 determines a PAM level for data transmission and/or reception, it requests the PAM adjustor 220 to make corresponding changes for that PAM level. Data transfer rate can be adjusted by adjusting the PAM levels without changes to the clock frequency. Maintaining the same clock frequency can eliminate the re-locking time needed for the phase-locked loop (PLL) or delay-locked loop (DLL). The memory controller 130 further includes a number of queues 210 to temporarily store read data, write data, and commands from the processor 110.

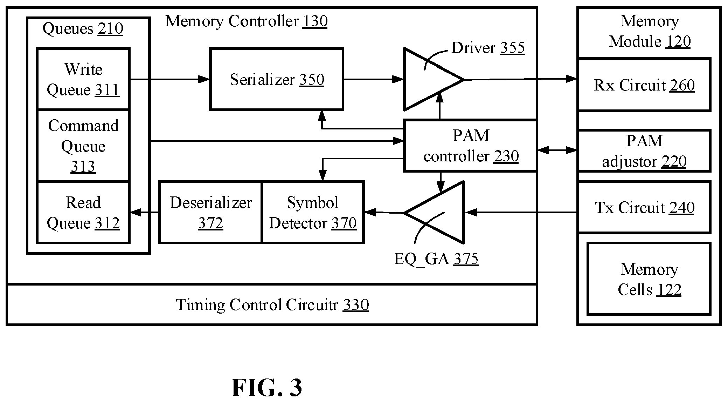

FIG. 3 is a block diagram illustrating further details of the memory controller 130 according to one embodiment. In the memory controller 130, the Tx circuit 250 sends data to the memory module 120, and the Rx circuit 270 receives data from the memory module 120. The Tx circuit includes, among other circuit components, a serializer 350 and a driver 355. The serializer 350 converts parallel outgoing data bits into a serial bitstream, and creates bit groups to form symbols according to a modulation scheme. Each bit group represents a symbol. For PAM-2 (a.k.a. non-return-to-zero (NRZ)), each symbol contains 1 bit; for PAM-4, each symbol contains 2 bits; for PAM-8, each symbol contains 3 bits, and so on. The Tx path further includes the driver 355, which converts serialized digital symbols into corresponding analog voltage levels.

The Rx circuit 270 includes, among other circuit components, an equalizer and gain amplifier circuit ("EQ_GA 375") to compensate for signal loss and distortion on the Rx path. The Rx circuit 270 further includes a symbol detector 370, which samples and detects the symbols in the received data signal. The output of the symbol detector 370 is a stream of bit groups with each bit group representing a symbol. A deserializer 372 converts the stream of symbols into parallel data for downstream digital circuitry.

In addition to the Tx circuit 250 and the Rx circuit 270, the memory controller 130 further includes timing control logic 330 to manage timing constraints on data communication. The queues 210 in the memory controller 130 further includes a write queue 311, a read queue 312, and a command queue 313. The read queue 312 temporarily stores incoming data bits to be forwarded to the processor 110 (FIG. 1), and the write queue 311 temporarily stores outgoing data bits to be sent to the memory module 120. The command queue 313 temporarily stores commands issued by the processor 110. Non-limiting examples of the commands include memory access commands such as read commands and write commands.

In one embodiment, the PAM controller 230 determines the PAM levels for data transmission and reception based on the rate at which write and read commands, respectively, are received by the memory controller 130. In one embodiment, the PAM controller 230 may monitor the number of read commands and the number of write commands waiting in the command queue 313 to be executed. In one embodiment, the PAM controller 230 may receive from the processor 110 more requests for data transfer in a first direction (i.e., one of Tx and Rx) than in a second direction (i.e., the other of Tx and Rx), and accordingly increase the PAM level for the first direction or decrease the PAM for the second direction. In one embodiment, the PAM controller 230 may determine to change the PAM level for the Tx circuit 250 based on the status of the write queue 311, e.g., when the occupied capacity of the write queue 311 exceeds an upper threshold (indicating a need for increasing PAM level) or below a lower threshold (indicating an opportunity for decreasing PAM level). Similarly, the PAM controller 230 may determine to change the PAM level for the Rx circuit 270 based on the status of the read queue 312. The PAM controller 230 can adjust the PAM levels for read and write independently of each other. That is, the memory controller 130 can transmit data to the memory module 120 at a first PAM level and receive data from the memory module 120 at a second PAM level, where the first PAM level can be different from the second PAM level.

When the PAM controller 230 determines to increase the PAM level for data transmission to the memory module 120, it signals the memory-side PAM adjustor 220 to coordinate a PAM level increase. The PAM controller 230 also signals the serializer 350 and the driver 355 to dynamically increase the PAM level without changing the clock frequency. When the serializer 350 increases the PAM level from, for example, PAM-2 to PAM-4, the serializer 350 dynamically changes the grouping of the outgoing bit stream from 1 bit to 2 bits per bit group. Correspondingly, the driver 355 also increases the number of voltage levels according to the increased PAM level, such that each bit group is mapped to a corresponding voltage level. The PAM adjustor 220 in the memory module 120 makes similar changes to the number of voltage levels according to the increased PAM level.

Conversely, when the PAM controller 230 determines to decrease the PAM level for data transmission, it signals the memory-side PAM adjustor 220 to coordinate a PAM level decrease. The PAM controller 230 signals the serializer 350 and the driver 355 to dynamically decrease the PAM level without changing the clock frequency. When decreasing the PAM level, the serializer 350 dynamically changes the grouping of the outgoing bit stream to reduce the number of bits per bit group. Correspondingly, the driver 355 also decreases the number of voltage levels according to the reduced PAM level. The PAM adjustor 220 in the memory module 120 makes similar changes to the number of voltage levels according to the reduced PAM level.

When the PAM controller 230 determines to increase the PAM level for receiving data from the memory module 120, it signals the memory-side PAM adjustor 220 to coordinate a PAM level increase. The PAM controller 230 then signals the symbol detector 370 to dynamically increase the PAM level without changing the clock frequency. For example, when the PAM level increases from PAM-2 to PAM-4, the symbol detector 370 increases the number of thresholds in the receiver voltage range according to the increased PAM level. In the example of PAM-4, the voltage (v) of each received data sample, after equalization and gain amplification, is compared with three voltage thresholds (e.g., T1, T2, and T3) that define the 4 voltage levels of PAM-4 (e.g., v < T1, T1 < v < T2, T2 < v < T3, and v > T3). The symbol detector 370 generates a symbol corresponding to the matched voltage level. Conversely, when the PAM level decreases, the symbol detector 370 decreases the number of voltage thresholds in the receiver voltage range such that the voltage of each received data sample, after equalization and gain amplification, is compared with the voltage thresholds of the decreased PAM level to identify a matched voltage level. The symbol detector 370 then generates a symbol corresponding to the matched voltage level. The PAM adjustor 220 in the memory module 120 makes similar changes to the number of voltage levels that map to the reduced PAM level.

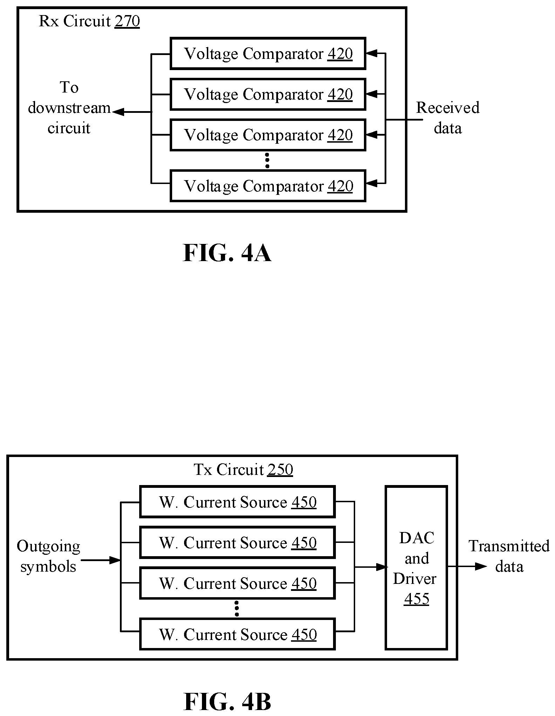

FIG. 4A is a block diagram illustrating an Rx circuit in the memory controller 130 according to one embodiment. Referring to FIG. 2 and FIG. 4A, the Rx circuit 270 includes a set of voltage comparators 420 (a.k.a. slicers) connected in parallel. Each voltage comparator 420 compares the voltage of the received data signal with a corresponding PAM voltage level. For example, a PAM-4 receiver may include three voltage comparators 420 with corresponding voltage thresholds at T1, T2, and T3, respectively. In one embodiment, the PAM controller 230 can dynamically turn on and off each individual voltage comparator 420 according to the PAM level chosen for data reception. The lower the PAM level, the fewer number of voltage comparators 420 are turned on and less power is consumed. Conversely, the higher the PAM level, the greater number of voltage comparators 420 are turned on and more power is consumed. Similarly, the Rx circuit 260 in the memory module 120 may have the same voltage comparators 420 or similar circuitry for data reception.

FIG. 4B is a block diagram illustrating a Tx circuit in the memory controller 130 according to one embodiment. Referring to FIG. 2 and FIG. 4B, the Tx circuit 250 includes weighted current sources 450 connected to a current-steering digital-to-analog (DAC) and driver 450. The memory controller 130 may activate a different set of weighted current sources 450 for different PAM levels. When increasing the PAM level in the transmission path for write operations, the memory controller 130 may activate additional weighted current sources 450 to generate the additional voltage levels for the increased PAM level. Conversely, when decreasing the PAM level in the transmission path for write operations, the memory controller 130 may inactivate some of the already-activated weighted current sources 450 to generate fewer voltage levels for the decreased PAM level.

The memory controller 130 may dynamically change the PAM levels in response to the power and performance needs of a system in which the memory controller 130 operates. A higher PAM level at the same clock frequency increases data transfer rate between the memory controller 130 and the memory module 120, as each symbol corresponds to more bits per unit time. A lower PAM level at the same clock frequency decreases the data transfer rate, as each symbol corresponds to fewer bits per unit time. A higher PAM level generally requires more power consumption as there are more voltage thresholds to compare at the receiver, and more voltage levels and more bits per voltage level to generate at the transmitter. Thus, decreasing the PAM level can help reduce power consumption.

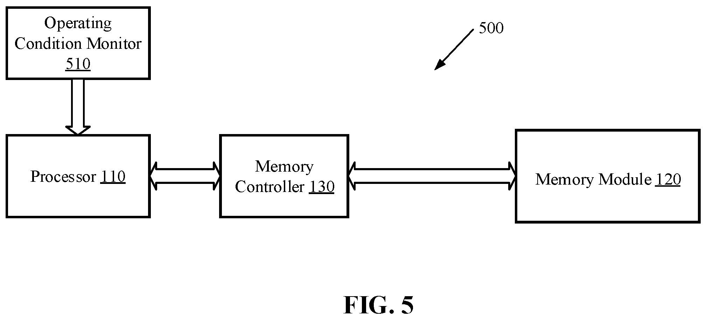

FIG. 5 is a block diagram illustrating an integrated circuit system ("system 500") in which the memory controller 130 may operate according to another embodiment. In this embodiment, the system 500 includes an operating condition monitor 510, which monitors the operating conditions of the system 500 and/or the processor 110. Non-limiting examples of the operating conditions include power consumption, workload, present or expected power and/or performance demands from the system 500 and/or the processor 110. Additionally, the operating conditions may also include workload demands from the software running on the processor 110 and/or the system 500, power/battery status, temperatures, and performance goals of the processor 110 and/or the system 500. Changes in the operating conditions can affect the performance of the system 500. When a change in the operation condition is detected by operating condition monitor 510, the system 500 may adjust the operating frequency and voltage of one or more processors using the dynamic voltage and frequency scaling (DVFS) technique. Additionally or alternatively, the system 500 may adjust the system performance by adjusting the memory I/O data transfer rate. For example, the system 500 may boost system performance by increasing the data transfer rate, or reduce power consumption by decreasing the data transfer rate. In one embodiment, performance boost and power reduction may be achieved by the memory controller 130 changing the PAM level for data transfer to and/or from the memory module 120.

In one embodiment, when a change in the operating conditions indicates a change in power status (e.g., when the system 500 enters a low-power mode or battery mode), there is a need for reduction in power consumption. In response to the change in the operating condition, the memory controller 130 can decrease the PAM level in one or both the transmit and receive directions. The decrease in the PAM level can be made independently of whether there is a change to the clock frequency. System performance can be improved by reducing memory I/O power consumption. Similarly, when a change in the operating conditions indicates a need for boosting the performance of the processor 110 and/or the system 500 (e.g., when workload increases), the memory controller 130 can increase the PAM level in one or both the transmit and receive directions to increase data transfer rate. The increase in the PAM level can be made independently of whether there is a change to the clock frequency. By changing the PAM levels for data transmission and/or reception, the system 500 may improve the system performance while maintaining the clock frequency of the processor 110, the memory controller 130, and the memory module 120.

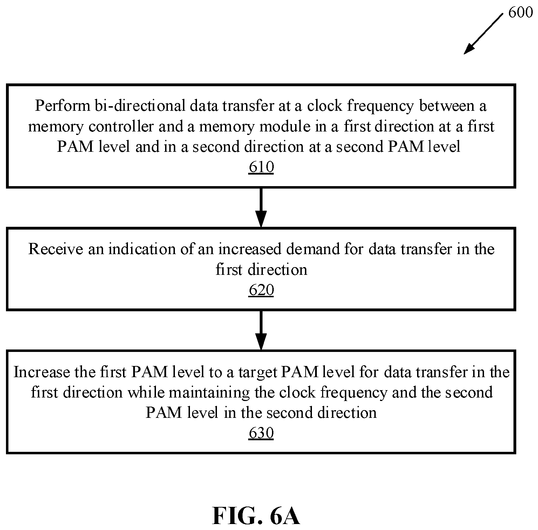

FIG. 6A is a flow diagram illustrating a method 600 performed by the memory controller 130 according to one embodiment. The method 600 starts at step 610 when the memory controller 130 performs bi-directional data transfer at a clock frequency between the memory controller and a memory module in a first direction at a first PAM level and in a second direction at a second PAM level. At step 620, the memory controller 130 receives an indication of an increased demand for data transfer in the first direction. At step 630, the memory controller 130 increases the first PAM level to a target PAM level for data transfer in the first direction while maintaining the clock frequency and the second PAM level in the second direction.

In one embodiment, when receiving another indication of a decreased demand for data transfer in the second direction, the memory controller decreases the second PAM level in the second direction independently of the target PAM level in the first direction. In one embodiment, the indication of an increased demand for data transfer in the first direction may be more requests for data transfer in the first direction than in the second direction, where the requests come from a processor coupled to the memory controller. In one embodiment, the memory controller adjusts the PAM levels for data transmission and reception based on statuses of a write queue and a read queue, respectively, in the memory controller.

In an embodiment where the first direction is a direction of reading from the memory module, the memory controller may activate additional voltage comparators when increasing the first PAM level. The voltage comparators are to compare a received data voltage with voltage thresholds of the target PAM level. In an embodiment where the first direction is a direction of writing to the memory module, the memory controller may activate additional weighted current sources to convert outgoing symbols to voltage levels of the target PAM level. In one embodiment, the memory module is a DDR-based memory module. In an alternative embodiment, the memory module is an HBM module.

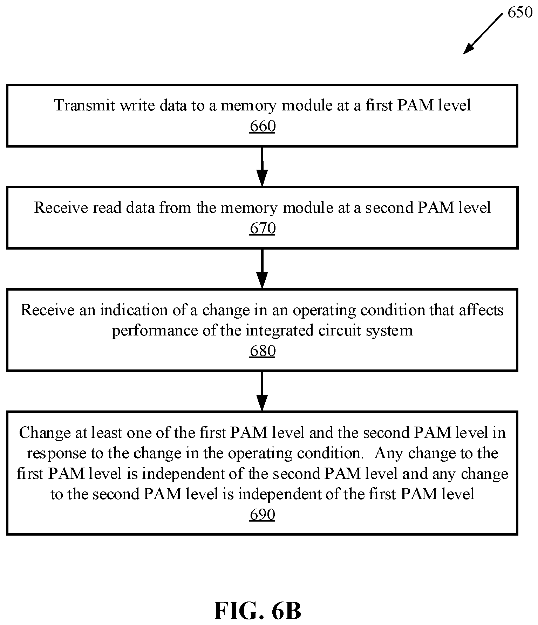

FIG. 6B is a flow diagram illustrating a method 650 performed by the memory controller 130 according to another embodiment. The method 650 starts at step 660 when the memory controller 130 transmits write data to a memory module at a first PAM level, and at step 670 when the memory controller 130 receives read data from the memory module at a second PAM level. At step 680, the memory controller 130 receives an indication of a change in an operating condition that affects performance of the integrated circuit system. At step 690, the memory controller 130 changes at least one of the first PAM level and the second PAM level in response to the change in the operating condition. Any change to the first PAM level is independent of the second PAM level and any change to the second PAM level is independent of the first PAM level.

In one embodiment, the memory controller dynamically increases at least one of the first PAM level and the second PAM level in response to an increase in workload of the integrated circuit system. In one embodiment, the memory controller dynamically decreases the at least one of the first PAM level and the second PAM level in response to the change in power status of the integrated circuit system. In one embodiment, the memory module is a DDR-based memory module. In an alternative embodiment, the memory module is an HBM module.

FIG. 7A-FIG. 7D illustrate the memory controller 130 connecting to different types of memory modules according to some embodiments. The memory controller 130 controls the PAM levels for reading from and writing to a memory module, where the PAM levels for read and write can be adjusted independently of each other. FIG. 7A shows that the memory controller 130 is connected to one or more memory dies 710. The memory dies 710 can be fabricated by any known fabrication technologies and can communicate with the memory controller 130 according to any known memory I/O protocols. For example, the memory dies 710 may be a dynamic random access memory (DRAM), synchronous DRAM (SDRAM), ferroelectric RAM (FeRAM), phase-change memory (PCM), etc. In FIG. 7B, the memory controller 130 communicates with a high bandwidth memory (HBM) module 720 that includes memory dies arranged in a vertical stack and accessible via TSVs 721. The memory controller 130 and the HBM modules 720 may be co-located on a base die 723, which is on top an interposer and substrate 725. It is noted that stacked memory technologies are not limited to the HBM module 720. The aforementioned memory controller 130 can operate with memory stacks formed by other memory technologies, such as low-power double data rate (LPDDR) memory stacks. In one embodiment, LPDDR memory dies may be wire-bonded into a vertical stack, with the bottom LPDDR die wire-bonded to a package substrate. Alternatively, the LPDDR memory stack may be encapsulated in a package. FIG. 7C shows the memory controller 130 in communication with DDR-based memory dies 730 such as DDR4, DDR5, DDR6, LPDDR, graphics DDR (GDDR) memory dies. The memory controller 130 and the DDR-based memory dies 730 may be co-located on the same package substrate 735. Alternatively, the DDR-based memory dies 730 may be in a separate package from the memory controller 130. FIG. 7D shows the memory controller 130 in communication with a DIMM 740 containing multiple memory dies. The memory controller 130 and the DIMM 740 may be co-located on the same printed circuit board (PCB) 745. The memory controller 130 in FIG. 7A-FIG. 7D performs the aforementioned memory access operations with dynamically adjustable PAM levels, and the PAM levels can be asymmetrically adjusted for read and write. More specifically, the operations performed by the memory controller 130 in FIG. 7A-FIG. 7D include the method 600 (FIG. 6A) and the method 650 (FIG. 6B).

The operations of the flow diagrams of FIG. 6A and FIG. 6B have been described with reference to the exemplary embodiments of FIG. 1-5 and 7. However, it should be understood that the operations of the flow diagrams of FIG. 6A and FIG. 6B can be performed by embodiments of the invention other than the embodiments of FIG. 1-5 and 7, and the embodiments of FIG. 1-5 and 7 can perform operations different than those discussed with reference to the flow diagrams. While the flow diagrams of FIG. 6A and FIG. 6B show a particular order of operations performed by certain embodiments of the invention, it should be understood that such order is exemplary (e.g., alternative embodiments may perform the operations in a different order, combine certain operations, overlap certain operations, etc.).

Various functional components or blocks have been described herein. As will be appreciated by persons skilled in the art, the functional blocks will preferably be implemented through circuits (either dedicated circuits or general-purpose circuits, which operate under the control of one or more processors and coded instructions), which will typically comprise transistors that are configured in such a way as to control the operation of the circuitry in accordance with the functions and operations described herein.

While the invention has been described in terms of several embodiments, those skilled in the art will recognize that the invention is not limited to the embodiments described, and can be practiced with modification and alteration within the spirit and scope of the appended claims. The description is thus to be regarded as illustrative instead of limiting.

Various embodiments are set out in the following numbered clauses.

Clause 1. A method of a memory controller in an integrated circuit system, comprising: performing bi-directional data transfer at a clock frequency between the memory controller and a memory module in a first direction at a first pulse amplitude modulation (PAM) level and in a second direction at a second PAM level; receiving an indication of an increased demand for data transfer in the first direction; and increasing the first PAM level to a target PAM level for data transfer in the first direction while maintaining the clock frequency and the second PAM level in the second direction.

Clause 2. The method of Clause 1, further comprising: receiving another indication of a decreased demand for data transfer in the second direction; and decreasing the second PAM level in the second direction independently of the target PAM level in the first direction.

Clause 3. The method of Clause 1, wherein receiving the indication further comprises: receiving, from a processor coupled to the memory controller, more requests for data transfer in the first direction than in the second direction.

Clause 4. The method of Clause 1, wherein the memory controller adjusts the PAM levels for data transmission and reception based on statuses of a write queue and a read queue, respectively, in the memory controller.

Clause 5. The method of Clause 1, wherein the first direction is a direction of reading from the memory module, the method further comprises:
activating additional voltage comparators when increasing the first PAM level to compare a received data voltage with voltage thresholds of the target PAM level.

Clause 6. The method of Clause 1, wherein the first direction is a direction of writing to the memory module, the method further comprises:
activating additional weighted current sources to convert outgoing symbols to voltage levels of the target PAM level.

Clause 7. The method of Clause 1, wherein the memory module is one of a double data rate (DDR)-based memory module and a high bandwidth memory (HBM) module.

Clause 8. A method of a memory controller in an integrated circuit system, comprising: transmitting write data to a memory module at a first pulse amplitude modulation (PAM) level; receiving read data from the memory module at a second PAM level; receiving an indication of a change in an operating condition that affects performance of the integrated circuit system; and changing at least one of the first PAM level and the second PAM level in response to the change in the operating condition, wherein any change to the first PAM level is independent of the second PAM level and any change to the second PAM level is independent of the first PAM level.

Clause 9. The method of Clause 8, further comprising: dynamically increasing the at least one of the first PAM level and the second PAM level in response to an increase in workload of the integrated circuit system.

Clause 10. The method of Clause 8, further comprising: dynamically decreasing the at least one of the first PAM level and the second PAM level in response to the change in power status of the integrated circuit system.

Clause 11. The method of Clause 1, wherein the memory module is one of a double data rate (DDR)-based memory module and a high bandwidth memory (HBM) module.

Clause 12. An integrated circuit system, comprising: a memory module including one or more memory dies; and a memory controller coupled to the memory module and a processor, the memory controller including a transmitter circuit and a receiver circuit to perform bi-directional data transfer at a clock frequency with the memory module in a first direction at a first pulse amplitude modulation (PAM) level and in a second direction at a second PAM level, wherein when the memory controller receives an indication of an increased demand for data transfer in the first direction, the memory controller increases the first PAM level to a target PAM level for data transfer in the first direction while maintaining the clock frequency and the second PAM level in the second direction.

Clause 13. The integrated circuit system of Clause 12, wherein, when the memory controller receives another indication of a decreased demand for data transfer in the second direction, the memory controller decreases the second PAM level in the second direction independently of the target PAM level in the first direction.

Clause 14. The integrated circuit system of Clause 12, wherein the memory controller is coupled to a processor, and wherein the indication of the increased demand is more requests from the processor for data transfer in the first direction than in the second direction.

Clause 15. The integrated circuit system of Clause 12, wherein the memory controller adjusts the PAM levels for data transmission and reception based on statuses of a write queue and a read queue, respectively, in the memory controller.

Clause 16. The integrated circuit system of Clause 12, wherein the first direction is a direction of reading from the memory module, and wherein the memory controller, when increasing the first PAM level, activates additional voltage comparators to compare a received data voltage with voltage thresholds of the target PAM level.

Clause 17. The integrated circuit system of Clause 12, wherein the first direction is a direction of writing to the memory module, and wherein the memory controller, when increasing the first PAM level, activates additional weighted current sources to convert outgoing symbols to voltage levels of the target PAM level.

Clause 18. The integrated circuit system of Clause 12, wherein, when the memory controller receives an indication of a change in operating conditions that affects performance of the integrated circuit system, the memory controller changes at least one of the first PAM level and the second PAM level in response to the change.

Clause 19. The integrated circuit system of Clause 11, wherein the memory module is a double data rate (DDR)-based memory module.

Clause 20. The integrated circuit system of Clause 11, wherein the memory module is a high bandwidth memory (HBM) module.

## Claims

1. A method (600) of a memory controller (130) in an integrated circuit system (100, 500), comprising:
performing (610) bi-directional data transfer at a clock frequency between the memory controller (130) and a memory module (120) in a first direction at a first pulse amplitude modulation, PAM, level and in a second direction at a second PAM level;
receiving (620) an indication of an increased demand for data transfer in the first direction; and
increasing (630) the first PAM level to a target PAM level for data transfer in the first direction while maintaining the clock frequency and the second PAM level in the second direction.

2. The method (600) of claim 1, further comprising:
receiving another indication of a decreased demand for data transfer in the second direction; and
decreasing the second PAM level in the second direction independently of the target PAM level in the first direction.

3. The method (600) of claim 1, wherein receiving the indication further comprises:
receiving, from a processor (110) coupled to the memory controller (130), more requests for data transfer in the first direction than in the second direction.

4. The method (600) of claim 1, wherein the memory controller (130) adjusts the PAM levels for data transmission and reception based on statuses of a write queue (311) and a read queue (312), respectively, in the memory controller (130).

5. The method (600) of claim 1, wherein the first direction is a direction of reading from the memory module (120), the method (600) further comprises: activating additional voltage comparators (420) when increasing the first PAM level to compare a received data voltage with voltage thresholds of the target PAM level; or
wherein the first direction is a direction of writing to the memory module (120), the method (600) further comprises: activating additional weighted current sources (450) to convert outgoing symbols to voltage levels of the target PAM level.

6. A method (650) of a memory controller (130) in an integrated circuit system (100, 500), comprising:
transmitting (660) write data to a memory module (120) at a first pulse amplitude modulation, PAM, level;
receiving (670) read data from the memory module (120) at a second PAM level;
receiving (680) an indication of a change in an operating condition that affects performance of the integrated circuit system (100, 500); and
changing (690) at least one of the first PAM level and the second PAM level in response to the change in the operating condition, wherein any change to the first PAM level is independent of the second PAM level and any change to the second PAM level is independent of the first PAM level.

7. The method (650) of claim 6, further comprising:
dynamically increasing the at least one of the first PAM level and the second PAM level in response to an increase in workload of the integrated circuit system (100, 500); or
dynamically decreasing the at least one of the first PAM level and the second PAM level in response to the change in power status of the integrated circuit system (100, 500).

8. The method (650) of claim 1 or 6, wherein the memory module (120) is one of a double data rate, DDR,-based memory module (120) and a high bandwidth memory, HBM, module.

9. An integrated circuit system (100, 500), comprising:
a memory module (120) including one or more memory dies (710); and
a memory controller (130) coupled to the memory module (120) and a processor (110), the memory controller (130) including a transmitter circuit and a receiver circuit to perform bi-directional data transfer at a clock frequency with the memory module (120) in a first direction at a first pulse amplitude modulation, PAM, level and in a second direction at a second PAM level,
wherein when the memory controller (130) receives an indication of an increased demand for data transfer in the first direction, the memory controller (130) increases the first PAM level to a target PAM level for data transfer in the first direction while maintaining the clock frequency and the second PAM level in the second direction.

10. The integrated circuit system (100, 500) of claim 9, wherein, when the memory controller (130) receives another indication of a decreased demand for data transfer in the second direction, the memory controller (130) decreases the second PAM level in the second direction independently of the target PAM level in the first direction.

11. The integrated circuit system (100, 500) of claim 9, wherein the memory controller (130) is coupled to a processor (110), and wherein the indication of the increased demand is more requests from the processor (110) for data transfer in the first direction than in the second direction.

12. The integrated circuit system (100, 500) of claim 9, wherein the memory controller (130) adjusts the PAM levels for data transmission and reception based on statuses of a write queue (311) and a read queue (312), respectively, in the memory controller (130).

13. The integrated circuit system (100, 500) of claim 9, wherein the first direction is a direction of reading from the memory module (120), and wherein the memory controller (130), when increasing the first PAM level, activates additional voltage comparators (420) to compare a received data voltage with voltage thresholds of the target PAM level; or
wherein the first direction is a direction of writing to the memory module (120), and wherein the memory controller (130), when increasing the first PAM level, activates additional weighted current sources (450) to convert outgoing symbols to voltage levels of the target PAM level.

14. The integrated circuit system (100, 500) of claim 9, wherein, when the memory controller (130) receives an indication of a change in operating conditions that affects performance of the integrated circuit system (100, 500), the memory controller (130) changes at least one of the first PAM level and the second PAM level in response to the change.

15. The integrated circuit system (100, 500) of claim 9, wherein the memory module (120) is one of a double data rate, DDR,-based memory module (120) and a high bandwidth memory, HBM, module (720).
